# EUROPEAN PATENT APPLICATION

(11) **EP 4 772 517 A1**
(43) Date of publication of application: **08.07.2026**
(21) Application number: 24859483.0
(22) Date of filing: 15.08.2024
(51) Int. Cl.: C07F 7/18, C09J 5/00, C23C 26/00

(54) **TETRAZOLE COMPOUND, METHOD FOR SYNTHESIZING SAID TETRAZOLE COMPOUND, AND USE THEREOF**

(30) Priority: 29.08.2023 JP 2023138677
(71) Applicant: SHIKOKU CHEMICALS CORPORATION, Marugame-shi, Kagawa 763-8504 (JP)
(72) Inventor: TAKASAKU, Koji, Ayauta-gun, Kagawa 769-0202 (JP); MURAI, Takayuki, Ayauta-gun, Kagawa 769-0202 (JP); NAKANISHI, Masato, Ayauta-gun, Kagawa 769-0202 (JP); FUJINO, Koki, Ayauta-gun, Kagawa 769-0202 (JP); TANIOKA, Miya, Ayauta-gun, Kagawa 769-0202 (JP); OKADA, Kazuki, Ayauta-gun, Kagawa 769-0202 (JP); WATANABE, Natsuki, Ayauta-gun, Kagawa 769-0202 (JP); KATSUMURA, Masato, Ayauta-gun, Kagawa 769-0202 (JP)
(74) Representative: Ipsilon
(86) International application number: PCT/JP2024/029068
(87) International publication number: WO 2025/047447

(57) **Abstract**

The present invention provides a novel tetrazole compound, a method for synthesizing the same, and a coupling agent. A tetrazole compound according to the present invention is represented by chemical formula (I). In chemical formula (I), R¹ and R² are the same or different and represent a hydrogen atom or a group represented by -(CH₂)ₘ-Si(OR)₃-ₚ(OH)ₚ, where R represents a methyl group or an ethyl group, m represents an integer of 1-18, and p represents an integer of 0-3. X represents a phenylene group, -NH-, or -(CH₂)ₙ-, and n represents an integer of 0-12. However, R¹ and R² are not simultaneously hydrogen atoms.

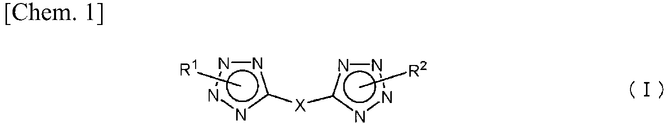

## Description

### TECHNICAL FIELD

The present invention relates to a novel tetrazole compound, a method for synthesizing the tetrazole compound, and use thereof.

### BACKGROUND ART

In the related art, coupling agents have been used to bond materials having different properties, such as organic materials and inorganic materials, and have been used in the fields of electronic materials, paints, primers, adhesives, and the like. Therefore, the coupling agents are essential agents for development and production of composite materials.

For example, a coupling agent (silane coupling agent) using a compound composed of an organic substance and silicon is known, and the silane coupling agent exhibits a function as an intermediate agent between an organic material and an inorganic material that are generally incompatible.

In addition, an azole compound such as a tetrazole compound has a function of preventing corrosion of a metal and a function of curing an epoxy resin or a urethane resin, and therefore, various coupling agents using an azole compound have been proposed.

As a coupling agent, for example, Patent Literature 1 proposes a triazole silane compound in which an alkoxysilyl group is introduced into a specific triazole ring. Patent Literature 2 proposes a triazole silane compound having specific two triazole rings and a disulfide bond (-S-S-), in which -CO-NH-(CH₂)ₘ-Si(OR)₃ is introduced into the triazole ring.

### CITATION LIST

### PATENT LITERATURE

Patent Literature 1: WO 2018/186476
Patent Literature 2: WO 2015/002158

### SUMMARY OF INVENTION

### TECHNICAL PROBLEM

In recent years, in the field of electric and electronic materials, in order to meet the demands of miniaturization, thinning, precision, high-speed propagation, and the like, it is required to improve adhesiveness between materials. The azole compounds as disclosed in Patent Literatures 1 and 2 can also exhibit excellent adhesiveness, but a compound capable of exhibiting higher adhesiveness has been required.

The present invention has been made in view of the above problems, and an object thereof is to provide a novel tetrazole compound, a method for synthesizing the novel tetrazole compound, and a coupling agent.

### SOLUTION TO PROBLEM

As a result of intensive studies to solve the above-described problems, the present inventors have found that the above-described problems can be solved by a tetrazole compound obtained by reacting a certain kind of tetrazole compound and a certain kind of halogenated alkylsilane compound, and have completed the present invention.

That is, a first aspect of the present invention provides a tetrazole compound represented by the chemical formula (I).

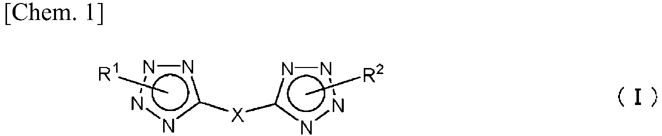

(In the formula (I), R¹ and R² are the same as or different from each other, and each represent a hydrogen atom or a group represented by -(CH₂)ₘ-Si(OR)₃₋ₚ(OH)ₚ, in which R represents a methyl group or an ethyl group, m represents an integer of 1 to 18, and p represents an integer of 0 to 3. X represents a phenylene group, -NH-, or a group represented by -(CH₂)ₙ-, and n represents an integer of 0 to 12. Here, the case where R¹ and R² are hydrogen atoms at the same time is excluded.)

A second aspect of the present invention provides a method for synthesizing the tetrazole compound according to the first aspect, and the method includes reacting a tetrazole compound represented by the chemical formula (II) and a halogenated alkylsilane compound represented by the chemical formula (III).

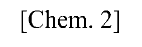

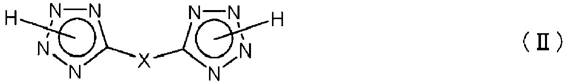

(In the formula (II), X is the same as that described above.)

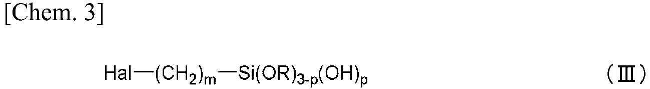

(In the formula (III), R, m, and p are the same as those described above. Hal represents a fluorine atom, a chlorine atom, a bromine atom, or an iodine atom.)

A third aspect of the present invention provides a coupling agent containing the tetrazole compound according to the first aspect of the present invention as a component.

A fourth aspect of the present invention provides a surface treatment liquid containing the tetrazole compound according to the first aspect of the present invention.

A fifth aspect of the present invention is directed to the surface treatment liquid according to the fourth aspect of the present invention, in which the surface treatment liquid is used for treating a surface of at least one selected from the group consisting of a metal, an inorganic material, and a resin material.

A sixth aspect of the present invention is directed to the surface treatment liquid according to the fourth aspect of the present invention, in which the surface treatment liquid is used for adhering two materials selected from the group consisting of a metal, an inorganic material, and a resin material to each other.

A seventh aspect of the present invention is directed to the surface treatment liquid according to the fifth or sixth aspect of the present invention, in which the metal is at least one selected from the group consisting of copper, aluminum, titanium, nickel, tin, iron, silver, gold, and alloys thereof.

An eighth aspect of the present invention provides a surface treatment method including bringing the surface treatment liquid according to any one of the fourth to seventh aspects of the present invention into contact with a surface of at least one selected from the group consisting of a metal, an inorganic material, and a resin material.

A ninth aspect of the present invention is directed to the surface treatment method according to the eighth aspect of the present invention, in which the metal is at least one selected from the group consisting of copper, aluminum, titanium, nickel, tin, iron, silver, gold, and alloys thereof.

A tenth aspect of the present invention is directed to the surface treatment method according to the eighth aspect or the ninth aspect of the present invention, in which the metal is copper or a copper alloy.

An eleventh aspect of the present invention is directed to the surface treatment method according to any one of the eighth to tenth aspects of the present invention, in which an aqueous solution containing copper ions is brought into contact with a surface of copper or a copper alloy before the surface treatment liquid is brought into contact with the surface of copper or the copper alloy.

A twelfth aspect of the present invention is directed to the surface treatment method according to any one of the eighth to eleventh aspects of the present invention, in which after the surface treatment liquid is brought into contact with the surface of the copper or the copper alloy, an acidic aqueous solution or an alkaline aqueous solution is brought into contact with the surface of the copper or the copper alloy.

A thirteenth aspect of the present invention provides an adhesion method including: bringing the surface treatment liquid according to any one of the fourth to seventh aspects of the present invention into contact with at least one selected from the group consisting of a metal, an inorganic material, and a resin material to form a chemical conversion film on the at least one; and adhering the at least one and another one of the group to each other via the chemical conversion film.

A fourteenth aspect of the present invention provides a method for adhering a metal and a resin material to each other, and the method includes: bringing the surface treatment liquid according to any one of the fourth to seventh aspects of the present invention into contact with at least one of the metal and the resin material to form a chemical conversion film on the at least one; and adhering the metal and the resin material to each other via the chemical conversion film.

A fifteenth aspect of the present invention provides a printed wiring board containing two materials selected from the group consisting of a metal, an inorganic material, and a resin material in which the two materials adhere to each other via a chemical conversion film formed by the surface treatment liquid according to any one of the fourth to seventh aspects of the present invention.

A sixteenth aspect of the present invention provides a semiconductor wafer containing two materials selected from the group consisting of a metal, an inorganic material, and a resin material in which the two materials adhere to each other via a chemical conversion film formed by the surface treatment liquid according to the fourth to seventh aspects of the present invention.

A seventeenth aspect of the present invention provides an insulating composition containing the coupling agent according to the third aspect of the present invention and a resin material or an inorganic material.

An eighteenth aspect of the present invention provides an insulating material containing the insulating composition according to the seventeenth aspect of the present invention.

A nineteenth aspect of the present invention provides a printed wiring board having an insulating layer obtained from the insulating composition according to the seventeenth aspect of the present invention.

A twentieth aspect of the present invention provides a semiconductor wafer having an insulating layer obtained from the insulating composition according to the seventeenth aspect of the present invention.

### ADVANTAGEOUS EFFECTS OF INVENTION

A tetrazole compound according to the present invention is a compound in which two tetrazole rings are bonded, the interaction with a metal, a resin material, or the like can be enhanced, and the two tetrazole rings are bonded by a linking group selected from the group consisting of a phenylene group, -NH-, and a group represented by -(CH₂)ₙ-. Therefore, the tetrazole compound is hardly decomposed by heat or an alkali.

In addition, a coupling agent according to the present invention contains, as a component, the tetrazole compound in which two tetrazole rings are linked by the linking group. Therefore, adhesiveness between materials having different properties can be enhanced. According to a surface treatment liquid containing the tetrazole compound, it is possible to enhance the adhesiveness between two materials having different material types, that is, a metal and an inorganic material, a metal and a resin material, and an inorganic material and a resin material.

### DESCRIPTION OF EMBODIMENTS

Hereinafter, the present invention will be described in detail. The present invention is not limited to the embodiments described below.

### (Tetrazole Compound)

A tetrazole compound according to the present invention is represented by the following chemical formula (I) (hereinafter, may be referred to as a tetrazole compound according to the present invention).

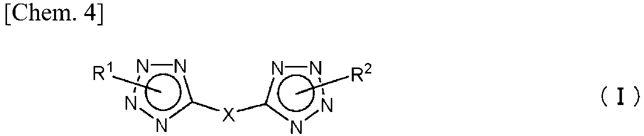

(In the formula (I), R¹ and R² are the same as or different from each other, and each represent a hydrogen atom or a group represented by -(CH₂)ₘ-Si(OR)₃₋ₚ(OH)ₚ, in which R represents a methyl group or an ethyl group, m represents an integer of 1 to 18, and p represents an integer of 0 to 3. X represents a phenylene group, -NH-, or a group represented by -(CH₂)ₙ-, and n represents an integer of 0 to 12. Here, the case where R¹ and R² are hydrogen atoms at the same time is excluded.)

In the group represented by -(CH₂)ₘ-Si(OR)₃₋ₚ(OH)ₚ, m is preferably an integer of 2 to 12, more preferably an integer of 3 to 10, and still more preferably an integer of 3 to 8.

X is preferably a group represented by -(CH₂)ₙ-, and n is more preferably an integer of 0 to 10, still more preferably an integer of 0 to 8, and particularly preferably 0 to 6.

In the tetrazole compound according to the present invention, R¹ and R² are preferably bonded to the N atom at the 1-position or the 2-position of the tetrazole ring.

Examples of the tetrazole compound according to the present invention include tetrazole compounds represented by chemical formulas (I-1) to (I-8).

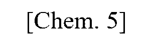

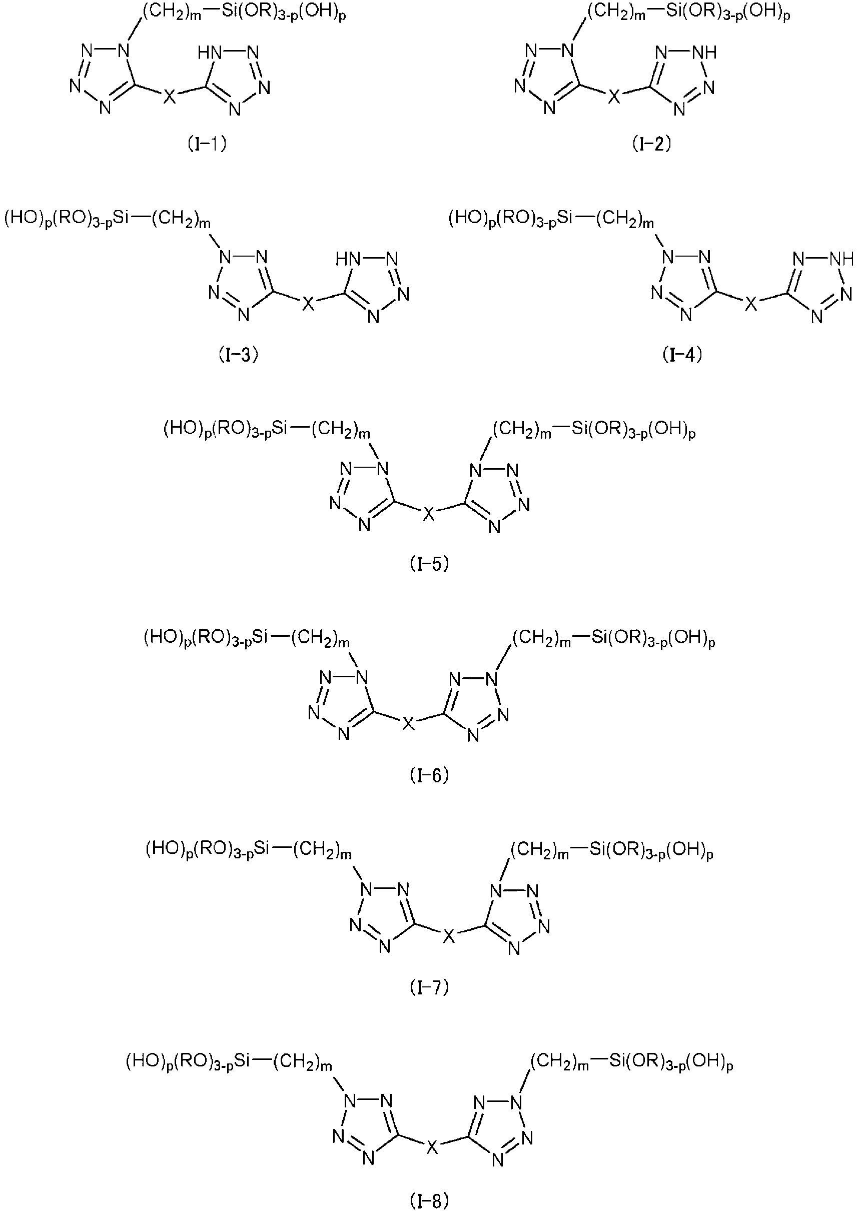

(In the formula (I-1) to the formula (I-8), X, m, p, and R are the same as those described above.)

Specific examples of the tetrazole compound according to the present invention in which R¹ is a group represented by -(CH₂)ₘ-Si(OR)₃₋ₚ(OH)ₚ, R² represents a hydrogen, and each of R¹ and R² is bonded to N at the 1-position of the tetrazole rings (compound represented by the chemical formula (I-1)) include
1-(trimethoxysilyl)methyl-5,5'-(1,4-phenylene)bis(1,2,3,4-tetrazole),
1-[2-(triethoxysilyl)ethyl]-5,5'-(1,2-phenylene)bis(1,2,3,4-tetrazole),
1-[3-(triethoxysilyl)propyl]-5,5'-(1,3-phenylene)bis(1,2,3,4-tetrazole),
1-[3-(triethoxysilyl)propyl]-5,5'-(1,4-phenylene)bis(1,2,3,4-tetrazole),
1-[6-(triethoxysilyl)hexyl]-5,5'-(1,4-phenylene)bis(1,2,3,4-tetrazole),
1-[3-(triethoxysilyl)propyl]-5,5'-iminobis(1,2,3,4-tetrazole),
1-[8-(trimethoxysilyl)octyl]-5,5'-iminobis(1,2,3,4-tetrazole),
1-[3-(triethoxysilyl)propyl]-5,5'-bi(1,2,3,4-tetrazole),
1-[10-(triethoxysilyl)decyl]-5,5'-bi(1,2,3,4-tetrazole),
1-[3-(triethoxysilyl)propyl]-5,5'-methylenebis(1,2,3,4-tetrazole),
1-[6-(trimethoxysilyl)hexyl]-5,5'-methylenebis(1,2,3,4-tetrazole),
1-[3-(triethoxysilyl)propyl]-5,5'-ethylenebis(1,2,3,4-tetrazole),
1-[12-(triethoxysilyl)dodecyl]-5,5'-ethylenebis(1,2,3,4-tetrazole),
1-[3-(triethoxysilyl)propyl]-5,5'-tetramethylenebis(1,2,3,4-tetrazole),
1-[3-(triethoxysilyl)propyl]-5,5'-pentamethylenebis(1,2,3,4-tetrazole),
1-[4-(triethoxysilyl)butyl]-5,5'-pentamethylenebis(1,2,3,4-tetrazole),
1-[3-(triethoxysilyl)propyl]-5,5'-hexamethylenebis(1,2,3,4-tetrazole),
1-[3-(triethoxysilyl)propyl]-5,5'-octamethylenebis(1,2,3,4-tetrazole),
1-[2-(trimethoxysilyl)ethyl]-5,5'-nonamethylenebis(1,2,3,4-tetrazole),
1-[2-(trimethoxysilyl)ethyl]-5,5'-decamethylenebis(1,2,3,4-tetrazole),
1-[3-(triethoxysilyl)propyl]-5,5'-undecamethylenebis(1,2,3,4-tetrazole), and
1-[3-(triethoxysilyl)propyl]-5,5'-dodecamethylenebis(1,2,3,4-tetrazole).

Specific examples of the tetrazole compound according to the present invention in which R¹ and R² are the same as or different from each other, and are a group represented by - (CH₂)ₘ-Si(OR)₃₋ₚ(OH)ₚ, and each of R¹ and R² is bonded to N at the 1-position of the tetrazole rings (compound represented by the chemical formula (I-5)) include:
5,5'-(1,4-phenylene)bis[1-(trimethoxysilyl)methyl-1,2,3,4-tetrazole],
5,5'-(1,2-phenylene)bis{1-[2-(triethoxysilyl)ethyl]-1,2,3,4-tetrazole},
5,5'-(1,3-phenylene)bis{1-[3-(triethoxysilyl)propyl]-1,2,3,4-tetrazole},
5,5'-(1,4-phenylene)bis{1-[3-(triethoxysilyl)propyl]-1,2,3,4-tetrazole},
5,5'-(1,4-phenylene)bis{1-[6-(triethoxysilyl)hexyl]-1,2,3,4-tetrazole},
5,5'-iminobis{1-[3-(triethoxysilyl)propyl]-1,2,3,4-tetrazole},
5,5'-iminobis{1-[8-(trimethoxysilyl)octyl]-1,2,3,4-tetrazole},
5,5'-bi{1-[3-(triethoxysilyl)propyl]-1,2,3,4-tetrazole},
5,5'-bi{1-[10-(triethoxysilyl)decyl]-1,2,3,4-tetrazole},
5,5'-methylenebis{1-[3-(triethoxysilyl)propyl]-1,2,3,4-tetrazole},
5,5'-methylenebis{1-[6-(trimethoxysilyl)hexyl]-1,2,3,4-tetrazole},
5,5'-ethylenebis{1-[3-(triethoxysilyl)propyl]-1,2,3,4-tetrazole},
5,5'-ethylenebis {1-[12-(triethoxysilyl)dodecyl]-1 ,2,3,4-tetrazole},
5,5'-tetramethylenebis{1-[3-(triethoxysilyl)propyl]-1,2,3,4-tetrazole},
5,5'-pentamethylenebis{1-[3-(triethoxysilyl)propyl]-1,2,3,4-tetrazole},
5,5'-pentamethylenebis{1-[4-(triethoxysilyl)butyl]-1,2,3,4-tetrazole},
5,5'-hexamethylenebis{1-[3-(triethoxysilyl)propyl]-1,2,3,4-tetrazole},
5,5'-octamethylenebis{1-[3-(triethoxysilyl)propyl]-1,2,3,4-tetrazole},
5,5'-nonamethylenebis{1-[2-(trimethoxysilyl)ethyl]-1,2,3,4-tetrazole},
5,5'-decamethylenebis{1-[2-(trimethoxysilyl)ethyl]-1,2,3,4-tetrazole},
5,5'-undecamethylenebis{1-[3-(triethoxysilyl)propyl]-1,2,3,4-tetrazole}, and
5,5'-dodecamethylenebis{1-[3-(triethoxysilyl)propyl]-1,2,3,4-tetrazole}.

When the tetrazole compound according to the present invention is used as a component of a coupling agent or a surface treatment liquid to be described below, different kinds of tetrazole compounds may be used in combination.

In addition, by reacting a halogenated alkylsilane compound represented by the following chemical formula (III), tetrazole compounds in a state in which isomers are mixed, such as a 1H-tetrazole compound (for example, a compound represented by the chemical formula (I-1)) and a 2H-tetrazole compound (for example, a compound represented by the chemical formula (I-3)), may be obtained and used. A mixing ratio (molar ratio) between the 1H-tetrazole compound and the 2H-tetrazole compound is preferably 5:95 to 95:5 and more preferably 20:80 to 80:20 from the viewpoint of production cost.

The tetrazole compound according to the present invention is obtained by reacting a tetrazole compound represented by the chemical formula (II) with a halogenated alkylsilane compound represented by the chemical formula (III).

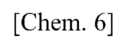

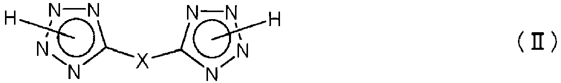

(In the formula (II), X is the same as that described above.)

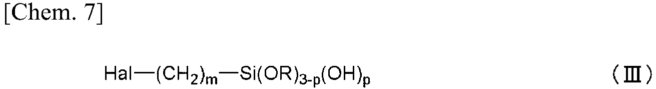

(In the formula (III), R, m, and p are the same as those described above. Hal represents a fluorine atom, a chlorine atom, a bromine atom, or an iodine atom.)

In the tetrazole compound represented by the chemical formula (II), X is the same as that in the tetrazole compound according to the present invention, and preferred ones are also the same.

In the halogenated alkylsilane compound represented by the chemical formula (III), R, m, and p are the same as those in the tetrazole compound according to the present invention, and preferred ones are also the same.

Hal in the halogenated alkylsilane compound represented by the chemical formula (III) is a fluorine atom, a chlorine atom, a bromine atom, or an iodine atom, and is preferably a chlorine atom or a bromine atom from the viewpoint of reactivity and availability of raw materials.

Examples of the tetrazole compound represented by the chemical formula (II) include:
5,5'-(1,4-phenylene)bis(1,2,3,4-tetrazole),
5,5'-(1,2-phenylene)bis(1,2,3,4-tetrazole),
5,5'-(1,3-phenylene)bis(1,2,3,4-tetrazole),
5,5'-iminobis(1,2,3,4-tetrazole),
5,5'-bi(1,2,3,4-tetrazole),
5,5'-methylenebis(1,2,3,4-tetrazole),
5,5'-ethylenebis(1,2,3,4-tetrazole),
5,5'-trimethylenebis(1,2,3,4-tetrazole),
5,5'-tetramethylenebis(1,2,3,4-tetrazole),
5,5'-pentamethylenebis(1,2,3,4-tetrazole),
5,5'-hexamethylenebis(1,2,3,4-tetrazole),
5,5'-heptamethylenebis(1,2,3,4-tetrazole),
5,5'-octamethylenebis(1,2,3,4-tetrazole),
5,5'-nonamethylenebis(1,2,3,4-tetrazole),
5,5'-decamethylenebis(1,2,3,4-tetrazole),
5,5'-undecamethylenebis(1,2,3,4-tetrazole), and
5,5'-dodecamethylenebis(1,2,3,4-tetrazole).

These tetrazole compounds exemplified above can be synthesized according to, for example, a synthesis method in WO 2015/084830.

These tetrazole compounds may also be used in a state of forming a salt with an appropriate base. Examples of the base include ammonia, lithium hydroxide, sodium hydroxide, and potassium hydroxide, and these can be used as an ammonium salt, a Li salt, a Na salt, and a K salt.

Examples of the halogenated alkylsilane compound represented by the chemical formula (III) include:
chloromethyltrimethoxysilane,
chloromethyltriethoxysilane,
2-chloroethyltrimethoxysilane,
2-chloroethyltriethoxysilane,
3-chloropropyltrimethoxysilane,
3-chloropropyltriethoxysilane,
3-bromopropyltrimethoxysilane,
3-bromopropyltriethoxysilane,
3-iodopropyltrimethoxysilane,
3-iodopropyltriethoxysilane,
4-bromobutyltrimethoxysilane,
4-bromobutyltriethoxysilane,
5-bromopentyltrimethoxysilane,
5-bromopentyltriethoxysilane,
6-bromohexyltrimethoxysilane,
6-bromohexyltriethoxysilane,
8-bromooctyltrimethoxysilane,
8-bromooctyltriethoxysilane,
10-bromodecyltrimethoxysilane,
10-bromodecyltriethoxysilane,
12-bromododecyltrimethoxysilane, and
12-bromododecyltriethoxysilane.

These exemplified halogenated alkylsilane compounds can be used by purchasing commercially available reagents, or can be synthesized in accordance with, for example, synthesis methods described in Chem. Eur. J., 18, 16742 (2012), J. Applied. Chem., 82, 276 (2009), and US 2,744,116A.

The tetrazole compound according to the present invention can be synthesized, for example, by reacting a tetrazole compound represented by the chemical formula (II) and a halogenated alkylsilane compound represented by the chemical formula (III) in the presence of a dehydrohalogenation agent in an appropriate amount of reaction solvent at an appropriate reaction temperature for an appropriate reaction time. The following scheme (A) shows a reaction scheme for obtaining a tetrazole compound (I-a) according to the present invention in which R¹ represents a hydrogen atom and R² represents a group represented by -(CH₂)ₘ-Si(OR)₃₋ₚ(OH)ₚ.

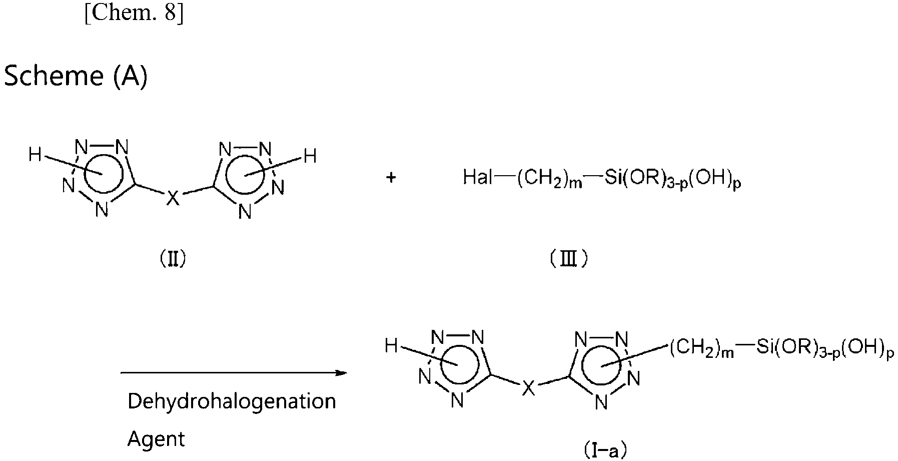

(In the formula (II), the formula (III), and the formula (I-a), X, R, Hal, m, and p are the same as those described above.)

The reaction solvent is not particularly limited as long as it is a solvent inert to the tetrazole compound represented by the chemical formula (II) and the halogenated alkylsilane compound represented by the chemical formula (III), and examples thereof include:
hydrocarbon solvents such as hexane, toluene, and xylene;
ether solvents such as diethyl ether, tetrahydrofuran, dioxane, and cyclopentyl methyl ether;
ester solvents such as ethyl acetate and butyl acetate;
alcohol solvents such as methanol and ethanol;
amide solvents such as N,N-dimethylformamide, N,N-dimethylacetamide, and N-methylpyrrolidone;
ketone solvents such as acetone, methyl ethyl ketone, methyl isobutyl ketone, and cyclohexanone; and
acetonitrile, dimethyl sulfoxide, and hexamethylphosphoramide.

Examples of the dehydrohalogenation agent include: alkali metal alkoxides such as sodium methoxide, sodium ethoxide, potassium methoxide, and potassium t-butoxide;
alkaline carbonates such as sodium carbonate and potassium carbonate; and
organic bases such as triethylamine and diazabicycloundecene, and sodium hydride.

The reaction between the tetrazole compound represented by the chemical formula (II) and the halogenated alkylsilane compound represented by the chemical formula (III) proceeds stoichiometrically as shown in the above scheme (A), but as for the usage amount (charged amount) of the halogenated alkylsilane compound represented by the chemical formula (III) with respect to the usage amount (charged amount) of the tetrazole compound represented by the chemical formula (II), it is preferable to use the halogenated alkylsilane compound represented by the chemical formula (III) in an amount of 0.8 to 1.2 equivalents with respect to each -NH of the tetrazole ring serving as a reaction point in consideration of factors such as reaction temperature, reaction time, type of raw material to be used, type of reaction solvent, and reaction scale.

In the case where the charged amount of the halogenated alkylsilane compound represented by the chemical formula (III) per reaction point (-NH) is more than 1.2 equivalents, the compound may be polymerized and gelated. In the case where the charged amount is less than 0.8 equivalents, the purity of the product may be reduced, or a separation operation of the product may be complicated.

In addition, the dehydrohalogenation agent is used to neutralize hydrogen halide produced as a by-product by the reaction of the tetrazole compound represented by the chemical formula (II) and the halogenated alkylsilane compound represented by the chemical formula (III), and therefore, the usage amount (charged amount) thereof may be equal to or more than the usage amount of the halogenated alkylsilane compound represented by the chemical formula (III).

The reaction temperature is not particularly limited as long as it falls within a temperature range in which -NH of the tetrazole ring of the tetrazole compound represented by the chemical formula (II) reacts with the halogenated alkylsilane compound represented by the chemical formula (III), and is preferably in a range of 0°C to 150°C and more preferably in a range of 5°C to 100°C.

The reaction time is appropriately determined according to the set reaction temperature, and is preferably in a range of 30 minutes to 48 hours, and more preferably in a range of 1 hour to 24 hours.

### (Coupling Agent)

The coupling agent according to the present invention contains the tetrazole compound represented by the chemical formula (I) as a component.

When the coupling agent according to the present invention is used, the same surface treatment method as in the case of a coupling agent according to the related art can be adopted.

Examples of the surface treatment method include (a) a method of spray-coating a base material with a treatment liquid obtained by diluting an appropriate amount of a coupling agent with an organic solvent, (b) a method of spray-coating a base material with a treatment liquid obtained by diluting the coupling agent with water and an organic solvent, (c) a method of spray-coating a base material with a treatment liquid obtained by diluting the coupling agent with water, (d) a method of immersing a base material in the treatment liquid obtained by diluting the coupling agent with an organic solvent, (e) a method of immersing a base material in the treatment liquid obtained by diluting the coupling agent with water and an organic solvent, and (f) a method of immersing a base material in the treatment liquid obtained by diluting the coupling agent with water.

Examples of the organic solvent include:
hydrocarbon solvents such as benzene, toluene, xylene, heptane, hexane, cyclohexane, and n-octane;
halogenated hydrocarbon solvents such as dichloromethane, dichloroethane, carbon tetrachloride, chloroform, chlorobenzene, dichlorobenzene, and trichlorobenzene;
ketone solvents such as acetone, methyl ethyl ketone, and methyl isobutyl ketone;
ether solvents such as diethyl ether, tetrahydrofuran, dioxane, ethylene glycol monomethyl ether (methyl cellosolve), ethylene glycol monoethyl ether (ethyl cellosolve), ethylene glycol monobutyl ether, and diethylene glycol monobutyl ether; and
alcohol solvents such as methanol, ethanol, 1-propanol, 2-propanol, n-butyl alcohol, 2-butyl alcohol, tert-butyl alcohol, ethylene glycol, diethylene glycol, and propylene glycol.

Examples of the base material used in the present invention include granular, needle-shaped, fibrous, woven, plate-shaped, foil-shaped, and amorphous base materials formed of a metal, an inorganic material, a resin material, or the like.

Examples of the metal include copper, aluminum, titanium, nickel, tin, iron, silver, gold, and alloys thereof, and a plate, a foil, or a plating film made of these metals can be used as a base material.

Specific examples of copper alloy are not particularly limited as long as the alloy is an alloy containing copper, and examples thereof include alloys such as a Cu-Ag alloy, a CuTe alloy, a Cu-Mg alloy, a Cu-Sn alloy, a Cu-Si alloy, a Cu-Mn alloy, a Cu-Be-Co alloy, a Cu-Ti alloy, a Cu-Ni-Si alloy, a Cu-Zn-Ni alloy, a Cu-Cr alloy, a Cu-Zr alloy, a Cu-Fe alloy, a Cu-Al alloy, a Cu-Zn alloy, and a Cu-Co alloy.

Examples of other alloys include an aluminum alloy (Al-Si alloy), a nickel alloy (Ni-Cr alloy), and an iron alloy (Fe-Ni alloy, stainless steel, steel).

Among these metals, copper and a copper alloy are preferable.

Examples of the inorganic material include silicon, ceramic, an inorganic material used as a filler, and glass.

Specific examples thereof include: silicon compounds such as silicon, silicon carbide, silica, glass, diatomaceous earth, calcium silicate, talc, glass beads, sericite, activated clay, bentonite, aluminosilicate, and mica; oxides such as alumina, zinc oxide, iron oxide, magnesium oxide, tin oxide, and titanium oxide; hydroxides such as magnesium hydroxide, aluminum hydroxide, and basic magnesium carbonate; carbonates such as calcium carbonate, zinc carbonate, hydrotalcite, and magnesium carbonate; sulfates such as barium sulfate and gypsum; titanates such as barium titanate; nitrides such as aluminum nitride and silicon nitride; and carbon fibers.

Among these inorganic materials, silicon, ceramics (alumina, silicon carbide, aluminum nitride, silicon nitride, barium titanate, and the like), and glass are preferable.

Examples of the resin material include nylon, an acrylate resin, an epoxy resin, a polybenzoxazole resin, a silicone resin, a polyimide resin, a bismaleimide resin, a maleimide resin, a cyanate resin, a polyphenylene ether resin, a polyphenylene oxide resin, a polybutadiene resin, an olefin resin, a fluorine-containing resin, a polyetherimide resin, a polyether ether ketone resin, and a liquid crystal resin, and these resins may be mixed or modified with each other to form a combination.

Among these resin materials, a polyphenylene ether resin, a polyphenylene oxide resin, a liquid crystal resin, an acrylate resin, an epoxy resin, an olefin resin, a polybenzoxazole resin, a silicone resin, and a polyimide resin are preferable.

By subjecting the base material to the surface treatment with the treatment liquid containing the coupling agent of the present invention, lipophilicity of the surface of the base material can be increased, and affinity (adhesion, adhesiveness) to a resin or the like can be improved.

In order to further exhibit the effect of this treatment, the surface-treated base material may be further heat-treated.

### (Surface Treatment Liquid)

### <Surface Treatment Liquid Containing Tetrazole Compound Represented by Chemical Formula (I)>

A surface treatment liquid according to the present invention contains a tetrazole compound represented by the chemical formula (I) (hereinafter, may be referred to as the tetrazole compound (I)). Among the tetrazole compounds (I), a compound in which p of the group represented by -(CH₂)ₘ-Si(OR)₃₋ₚ(OH)ₚ of R¹ and/or R² is an integer of 1 to 3 is a species that is generated by hydrolysis of a compound in which p is 0 in the surface treatment liquid. All of these are suitable as a component of the surface treatment liquid. In addition, among the tetrazole compounds (I), the compound in which p is an integer of 1 to 3 can be extracted from the surface treatment liquid by removing a volatile component from a surface treatment liquid containing the tetrazole compound (I) in which p is 0.

In an embodiment of the present invention, a compound in which p is 0, that is, a tetrazole compound (I) in which at least one of R¹ and R² is a group represented by -(CH₂)ₘ-Si(OR)₃ is preferably used as a raw material for preparing the surface treatment liquid.

The surface treatment liquid according to the present invention can be prepared by mixing a tetrazole compound (I) and water.

The water used for preparing the surface treatment liquid is preferably pure water such as ion exchange water or distilled water.

In addition, in the surface treatment liquid according to the present invention, it is preferable to use a solubilizing agent in order to promote dissolution (aqueous solution formation) of the tetrazole compound (I). Examples of the solubilizing agent include an acid, an alkali, and an organic solvent. One kind of these solubilizing agents may be used alone, or two or more kinds thereof may be used in combination.

Regarding a method for preparing the surface treatment liquid in the case of using a solubilizing agent and water, the solubilizing agent may be added after mixing the tetrazole compound with water, the tetrazole compound may be mixed with a mixed solution of the solubilizing agent and water, or water may be added after mixing the tetrazole compound with the solubilizing agent.

Examples of the acid include inorganic acids such as hydrochloric acid, sulfuric acid, nitric acid, and phosphoric acid; and organic acids such as formic acid, acetic acid, propionic acid, butyric acid, 2-ethylbutyric acid, valeric acid, caproic acid, enanthic acid, caprylic acid, pelargonic acid, capric acid, lauric acid, myristic acid, palmitic acid, margaric acid, oleic acid, stearic acid, glycolic acid, lactic acid, gluconic acid, glyceric acid, malonic acid, succinic acid, levulinic acid, benzoic acid, oxalic acid, tartaric acid, malic acid, benzenesulfonic acid, tosylic acid, methanesulfonic acid, 5-sulfosalicylic acid, 4-hydroxybenzenesulfonic acid, 3-methyl-4-hydroxybenzenesulfonic acid, 4-aminobenzenesulfonic acid, camphorsulfonic acid, benzenedisulfonic acid, benzenetrisulfonic acid, sulfamic acid, and amino acids. One kind of these acids may be used alone, or two or more kinds thereof may be used in combination.

Examples of the alkali include hydroxides of alkali metals, such as sodium hydroxide and potassium hydroxide, and amines such as ammonia, methylamine, dimethylamine, trimethylamine, ethylamine, diethylamine, triethylamine, propylamine, isopropylamine, butylamine, pentylamine, hexylamine, heptylamine, octylamine, nonylamine, allylamine, ethylenediamine, diethylenetriamine, triethylenetetramine, monoethanolamine, diethanolamine, triethanolamine, monopropanolamine, dipropanolamine, tripropanolamine, monoisopropanolamine, diisopropanolamine, triisopropanolamine, 2-amino-1-propanol, N,N-dimethylethanolamine, cyclohexylamine, aniline, pyrrolidine, piperidine, piperazine, and pyridine. One kind of these alkalis may be used alone, or two or more kinds thereof may be used in combination.

Examples of the organic solvent include methanol, ethanol, 1-propanol, 2-propanol, butanol, tert-butyl alcohol, ethylene glycol, propylene glycol, 1,4-butanediol, glycerin, diethylene glycol, triethylene glycol, ethylene glycol monomethyl ether, ethylene glycol dimethyl ether, ethylene glycol monoethyl ether, ethylene glycol diethyl ether, ethylene glycol monobutyl ether, propylene glycol monomethyl ether, propylene glycol monoethyl ether, propylene glycol monobutyl ether, diethylene glycol monomethyl ether, diethylene glycol dimethyl ether, diethylene glycol monoethyl ether, diethylene glycol diethyl ether, diethylene glycol monobutyl ether, triethylene glycol dimethyl ether, triethylene glycol diethyl ether, tetrahydrofurfuryl alcohol, furfuryl alcohol, acetone, tetrahydrofuran, dioxane, acetonitrile, 2-pyrrolidone, formamide, dimethylformamide, dimethylacetamide, dimethyl sulfoxide, sulfolane, dimethyl carbonate, ethylene carbonate, N-methylpyrrolidone, γ-butyrolactone, and 1,3-dimethyl-2-imidazolidinone. One kind of these organic solvents may be used alone, or two or more kinds thereof may be used in combination.

The content of the solubilizing agent is preferably 0.1 wt% to 99 wt% in the surface treatment liquid, more preferably 0.5 wt% to 99 wt%, and still more preferably 1 wt% to 99 wt%.

### <Hydrolysis of Tetrazole Compound (I)>

The tetrazole compound (I) has a tetrazole ring in the molecule, and therefore, the tetrazole ring interacts with a surface of the base material (metal, a resin material, and an inorganic material) to form a chemical bond. Therefore, adhesiveness between different materials can be improved.

A mode of hydrolysis of the tetrazole compound (I) is shown in a scheme (B). The scheme (B) exemplifies a case where at least one of R¹ and R² of the tetrazole compound (I) is a group represented by -(CH₂)ₘ-Si(OR)₃₋ₚ(OH)ₚ.

The scheme (B) shows a mode in which an alkoxysilyl group of the tetrazole compound (I) is hydrolyzed, that is, a mode in which the trialkoxysilyl group gradually changes to a dialkoxyhydroxysilyl group, a dihydroxyalkoxysilyl group, and a trihydroxysilyl group.

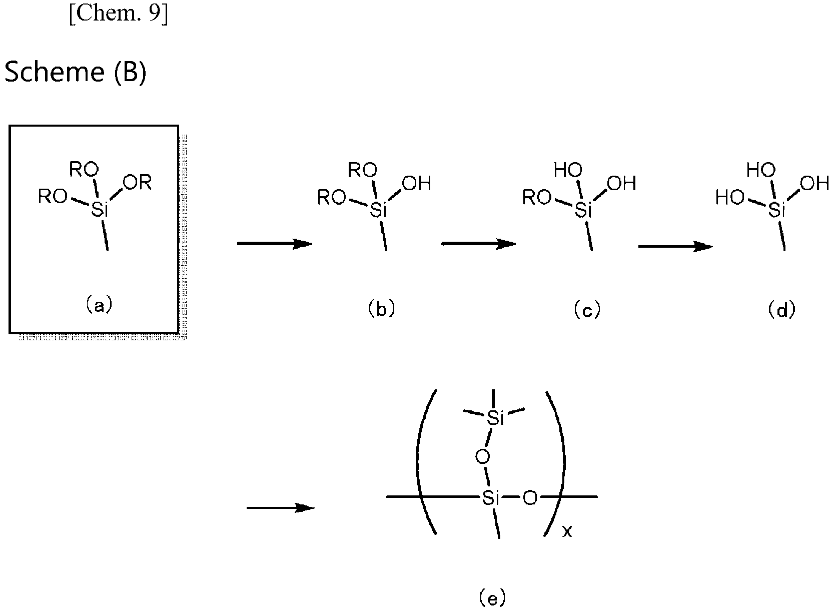

It is generally known that a substance having an alkoxysilyl group in the molecule acts as a silane coupling agent.

For example, in the case of adhesion between copper and a resin material, when the tetrazole compound (I) used in the embodiment of the present invention has an alkoxysilyl group in the molecule, the tetrazole ring interacts with the resin and copper to form a chemical bond, the alkoxysilyl group (-Si-OR) is hydrolyzed to be converted into a hydroxysilyl group (-Si-OH), and the hydroxysilyl group is chemically bonded to copper oxide scattered on the surface of copper.

Therefore, when copper is brought into contact with the surface treatment liquid, a chemical conversion film derived from the tetrazole compound (I) is formed on the surface of the copper due to bonding to the tetrazole ring or the hydroxysilyl group. When a resin layer made of a resin material is formed on the surface of the chemical conversion film, adhesiveness between the copper and the resin material can be enhanced as compared with the case where the resin layer is directly formed on the surface of the copper.

In the embodiment of the present invention, the concentration of the tetrazole compound (I) in the surface treatment liquid is preferably 0.0001 mol/L to 1 mol/L, more preferably 0.001 mol/L to 0.5 mol/L, and still more preferably 0.01 mol/L to 0.1 mol/L in terms of the concentration of the tetrazole compound in trialkoxy form.

By the way, the tetrazole compounds (I) having a hydroxysilyl group generated in the surface treatment liquid gradually react with each other to be dehydrated and condensed, and the hydroxysilyl group forms a siloxane bond (Si-O-Si (see the scheme (B)), and the tetrazole compound (I) is converted into a silane oligomer (a tetrazole compound having a group represented by the chemical formula (e) in the scheme (B)) which is hardly soluble in water. Note that X in the group represented by the chemical formula (e) is an integer representing the number of repeating units.

If the amount of the silane oligomer generated in the surface treatment liquid increases, insoluble components may precipitate (the treatment liquid may become cloudy) and adhere to a treatment tank, a pipe connected to the treatment tank, and sensors immersed in the treatment liquid to detect the temperature and liquid level of the treatment liquid, which may inhibit a smooth surface treatment.

In order to avoid this, in the preparation of the surface treatment liquid, the above-described organic solvent is preferably contained in the surface treatment liquid as a solubilizing agent for the silane oligomer that is hardly soluble in water. In addition, in the preparation of the surface treatment liquid, in order to promote the dissolution of the tetrazole compound (I), it is preferable to contain the above-described solubilizing agent (an acid, an alkali, or an organic solvent). Since the organic solvent also functions as a solubilizing agent for the silane oligomer, the surface treatment liquid according to the present invention preferably contains at least one selected from the group consisting of an acid, an alkali, and an organic solvent as the solubilizing agent.

Similarly, in order to improve the stability of the surface treatment liquid and the uniformity of the chemical conversion film, a substance that generates a halide ion such as fluoride ion, chloride ion, bromide ion, and iodide ion, and a metal ion such as copper ion, iron ion, and zinc ion may also be used.

The halide ion exhibits an effect of uniformly forming a flat portion of the chemical conversion film. Examples of the substance that generates a halide ion include lithium fluoride, sodium fluoride, potassium fluoride, magnesium fluoride, calcium fluoride, lithium chloride, sodium chloride, potassium chloride, magnesium chloride, calcium chloride, lithium bromide, sodium bromide, potassium bromide, magnesium bromide, calcium bromide, lithium iodide, sodium iodide, potassium iodide, magnesium iodide, calcium iodide, ammonium fluoride, ammonium chloride, ammonium bromide, ammonium iodide, cuprous chloride, cupric chloride, cuprous bromide, and cupric bromide. The halogen compound may be contained as an impurity of other components.

The content of the halide ions in the surface treatment liquid is not particularly limited, and is, for example, preferably 0.1 mol/L or less (particularly 0 mol/L to 0.1 mol/L), more preferably 0.05 mol/L or less (particularly 0 mol/L to 0.05 mol/L), still more preferably 0.02 mol/L or less (particularly 0 mol/L to 0.02 mol/L), and particularly preferably 0.01 mol/L or less (particularly 0 mol/L to 0.01 mol/L).

The copper ion forms a complex with the tetrazole compound (I), and can increase the strength of the chemical conversion film or the adhesive strength between metal and a resin. The valence of the copper ion may be monovalent or divalent. Examples of the substance that generates a copper ion include metal copper, copper sulfate (and a hydrate thereof (particularly pentahydrate)), copper formate (and a hydrate thereof (particularly tetrahydrate)), copper nitrate, cuprous chloride, cupric chloride, copper acetate (and a hydrate thereof (particularly monohydrate)), copper hydroxide, copper oxide, copper sulfide, copper carbonate, cuprous bromide, cupric bromide, copper phosphate, and copper benzoate.

The copper ions in the surface treatment liquid may contain copper ions eluted from metal copper or copper oxide contained in a copper circuit during the treatment of the copper circuit with the surface treatment liquid.

The content of the copper ions in the surface treatment liquid is not particularly limited, and is, for example, preferably 1 mol/L or less (particularly 0 mol/L or more and 1 mol/L or less), more preferably 0.5 mol/L or less (particularly 0 mol/L or more and 0.5 mol/L or less), still more preferably 0.1 mol/L or less (particularly 0 mol/L or more and 0.1 mol/L or less), and particularly preferably 0.01 mol/L or less (particularly 0 mol/L or more and 0.01 mol/L or less).

Known coupling agents may be used in combination as long as the effects of the present invention are not impaired. Examples of known coupling agents include silane-based coupling agents (silane coupling agents) having a thiol group (mercapto group), a vinyl group, an epoxy group, a (meth)acrylic group, an amino group, a chloropropyl group, or the like.

Examples of such a silane coupling agent include:
mercaptosilane compounds such as 3-mercaptopropyltrimethoxysilane and
3-mercaptopropylmethyldimethoxysilane;
vinylsilane compounds such as vinyltrichlorosilane,
vinyltrimethoxysilane, and
vinyltriethoxysilane;
styrylsilane compounds such as p-styryltrimethoxysilane;
epoxysilane compounds such as 2-(3,4-epoxycyclohexyl)ethyltrimethoxysilane,
3-glycidoxypropyltrimethoxysilane,
3-glycidoxypropylmethyldiethoxysilane, and
3-glycidoxypropyltriethoxysilane;
acryloxysilane compounds such as 3-acryloxypropyltrimethoxysilane;
methacryloxysilane compounds such as 3-methacryloxypropylmethyldimethoxysilane,
3-methacryloxypropyltrimethoxysilane,
3-methacryloxypropylmethyldiethoxysilane, and
3-methacryloxypropyltriethoxysilane;
aminosilane compounds such as N-2-(aminoethyl)-3-aminopropylmethyldimethoxysilane,
N-2-(aminoethyl)-3-aminopropyltrimethoxysilane,
N-2-(aminoethyl)-3-aminopropyltriethoxysilane,
3-aminopropyltrimethoxysilane,
3-aminopropyltriethoxysilane,
3-triethoxysilyl-N-(1,3-dimethyl-butylidene)propylamine,
N-phenyl-3-aminopropyltrimethoxysilane,
N-(vinylbenzyl)-2-aminoethyl-3-aminopropyltrimethoxysilane;
ureidosilane compounds such as 3-ureidopropyltriethoxysilane;
chloropropylsilane compounds such as 3-chloropropyltrimethoxysilane;
sulfide silane compounds such as bis(triethoxysilylpropyl)tetrasulfide; and
isocyanatosilane compounds such as 3-isocyanatopropyltriethoxysilane.

Other examples include aluminum-based coupling agents, titanium-based coupling agents, and zirconium-based coupling agents.

The surface treatment liquid according to the present invention can generally be adjusted to have a pH of -1 to 12. The surface treatment liquid according to the present invention preferably has a pH of 3 to 11.5. It is more preferable that the surface treatment liquid has a pH of 3 to 7 in the acidic region, and it is more preferable that the surface treatment liquid has a pH of 8 to 11.5 in the basic region. It is still more preferable that the surface treatment liquid has a pH of 8.5 to 9.5.

### (Treatment Method)

A method of bringing the surface treatment liquid according to the present invention into contact with the surface of the base material is not particularly limited, and methods such as spraying, immersion, or coating can be adopted as in the case of the coupling agent described above.

The time (treatment time) for bringing the surface treatment liquid into contact with the base material is preferably 1 second to 10 minutes, and more preferably 5 seconds to 3 minutes. In the case where the treatment time is shorter than 1 second, the film thickness of the chemical conversion film formed on the base material surface becomes thin, and it is difficult to obtain a sufficient adhesive force between materials of different properties. On the other hand, even in the case where the treatment time is longer than 10 minutes, there is no large difference in the film thickness of the chemical conversion film, and thus it is preferable to perform the treatment within 10 minutes from the viewpoint of productivity.

The temperature of the treatment liquid when the surface treatment liquid is brought into contact with the base material surface is preferably 5°C to 50°C, but may be appropriately set in relation to the treatment time.

After the surface treatment liquid according to the present invention is brought into contact with the base material, the base material may be washed with water and then dried, or may be dried without washing with water.

The drying is preferably performed at a temperature of room temperature to 150°C.

The water used for washing with water is preferably pure water such as ion exchange water or distilled water, but the method and time for washing with water are not particularly limited, and a method such as spraying or immersion for an appropriate time may be used.

The film thickness of the chemical conversion film is preferably 0.5 nm to 1000 nm, more preferably 1 nm to 200 nm, and still more preferably 1 nm to 100 nm. In the case where the film thickness is 0.5 nm or more, adhesiveness between materials is sufficiently enhanced, and in the case where the film thickness is 1000 nm or less, chemical resistance of the chemical conversion film can be maintained.

In the present invention, a surface of the chemical conversion film may be modified by subjecting the chemical conversion film after drying to a treatment such as plasma, laser, ion beam, ozone, heating, or humidification. Alternatively, the cleaning for the purpose of removing the resin and ion residues on the metal surface may be performed by using a processing method such as mechanical polishing using plasma, laser, ion beam, and pumice brush, or drilling.

Before the surface treatment liquid according to the present invention is brought into contact with the surface of copper or a copper alloy (hereinafter, both may be simply referred to as copper), at least one pretreatment selected from pickling treatment, alkali treatment, roughening treatment, heat resistance treatment, rust prevention treatment, and chemical conversion treatment may be performed on the surface of copper.

The pickling treatment is performed to remove oil and fat components adhering to the surface of copper and to remove an oxide film on the surface of copper. For this pickling treatment, a solution such as a hydrochloric acid-based solution, a sulfuric acid-based solution, a nitric acid-based solution, a sulfuric acid-hydrogen peroxide-based solution, an organic acid-based solution, an inorganic acid-organic solvent-based solution, or an organic acid-organic solvent-based solution can be used.

The alkali treatment is performed to remove oil and fat components adhering to the surface of copper and to remove residues (for example, a dry film resist for forming a copper circuit) in the previous step. For the alkali treatment, a solution such as an aqueous solution or an organic solvent solution containing alkali metal hydroxides such as sodium hydroxide and potassium hydroxide, amines such as ammonia, ethanolamine, monopropanolamine, and tetramethylammonium hydroxide, sodium carbonate, sodium hydrogen carbonate, potassium carbonate, potassium hydrogen carbonate, ammonium carbonate, ammonium hydrogen carbonate, sodium acetate, potassium acetate, sodium phosphate, disodium hydrogen phosphate, potassium phosphate, or dipotassium hydrogen phosphate can be used.

The roughening treatment is performed to enhance adhesiveness between copper and a resin by an anchor effect, and an uneven shape is imparted to the surface of copper, so that adhesiveness between copper and a resin material can be enhanced. In the roughening treatment, methods such as a micro-etching method, an electroplating method, an electroless plating method, an oxidation method (black oxide, brown oxide), an oxidation-reduction method, a brush polishing method, and a jet scrubbing method can be adopted.

In the micro-etching method, for example, an organic acid-cupric ion etching agent, a sulfuric acid-hydrogen peroxide etching agent, a persulfate etching agent, a copper chloride etching agent, or an iron chloride etching agent can be used. In the electroplating method, fine copper particles are deposited on the surface of copper to form unevenness on the surface of copper.

In the heat resistance treatment, a film of at least one selected from nickel, nickel-phosphorus, zinc, zinc-nickel, copper-zinc, copper-nickel, copper-nickel-cobalt, and nickel-cobalt is formed on the surface of copper. The film can be formed by adopting a known electroplating method, but the method is not limited to electroplating, and vapor deposition or other methods may be used.

The rust prevention treatment is performed to prevent oxidation corrosion of the surface of copper, and a method for forming a zinc or zinc alloy plating film, or an electrolytic chromate plating film on the surface of copper can be adopted. A treatment liquid containing an organic compound-based rust inhibitor such as a benzotriazole-based rust inhibitor may be brought into contact with the surface of copper.

In the chemical conversion treatment, a method for forming a tin passivation film or a method for forming a copper oxide passivation film can be adopted.

Before and/or after the surface treatment liquid according to the present invention is brought into contact with the surface of copper, an aqueous solution containing copper ions may be brought into contact with the surface of copper. The aqueous solution containing copper ions has a function of enhancing the film-forming property of the chemical conversion film formed on the surface of copper and a function of making the thickness of the chemical conversion film formed on the surface of copper uniform. The valence of the copper ion is not particularly limited, and the copper ion is a monovalent or divalent copper ion.

The copper ion source of the aqueous solution containing copper ions is not particularly limited as long as it is a copper salt soluble in water, and examples thereof include copper salts such as copper sulfate, copper nitrate, copper chloride, copper formate, and copper acetate. Ammonia or hydrochloric acid may be added to solubilize the copper salt in water.

Before and/or after the surface treatment liquid according to the present invention is brought into contact with the surface of copper, an acidic aqueous solution or an alkaline aqueous solution may be brought into contact with the surface of copper. The acidic aqueous solution or the alkaline aqueous solution also has a function of making the thickness of the chemical conversion film formed on the surface of copper uniform, similarly to the aqueous solution containing copper ions.

The acidic aqueous solution and the alkaline aqueous solution are not particularly limited, and examples of the acidic aqueous solution include an aqueous solution containing a mineral acid such as sulfuric acid, nitric acid, and hydrochloric acid, and an aqueous solution containing an organic acid such as formic acid, acetic acid, lactic acid, glycolic acid, and amino acids. Examples of the alkaline aqueous solution include aqueous solutions containing alkali metal hydroxides such as sodium hydroxide and potassium hydroxide, amines such as ammonia, ethanolamine, monopropanolamine, and tetramethylammonium hydroxide, sodium carbonate, sodium hydrogen carbonate, potassium carbonate, potassium hydrogen carbonate, ammonium carbonate, ammonium hydrogen carbonate, sodium acetate, potassium acetate, sodium phosphate, disodium hydrogen phosphate, potassium phosphate, or dipotassium hydrogen phosphate.

Before and/or after the surface treatment liquid according to the present invention is brought into contact with the surface of copper, an aqueous solution containing a known coupling agent may be brought into contact with the surface of copper.

Before and/or after the surface treatment agent according to the present invention is brought into contact with the surface of copper, a dipping solution containing an azole compound may be brought into contact with the surface of copper. The dipping solution has a function of increasing the strength of the chemical conversion film formed on the surface of copper.

The azole compound is not particularly limited, and examples thereof include commercially available imidazole compounds, triazole compounds, and tetrazole compounds. Examples of the azole compounds include imidazole, 2-methylimidazole, 1,2,3-triazole, 1,2,4-triazole, 3-amino-1,2,4-triazole, 3-amino-5-methyl-1,2,4-triazole, 5-methyltetrazole, 5-aminotetrazole, and 5-phenyltetrazole.

The dipping solution contains water and/or a solubilizing agent in addition to the azole compound. Examples of the solubilizing agent include the solubilizing agents described above (acids, alkalis, and organic solvents).

The dipping solution may further contain an additive. Examples of the additive include a copper compound, a halogen compound, and other additives (for example, ammonium salts such as ammonium sulfate, ammonium formate, ammonium acetate, ammonium chloride, ammonium carbonate, and ammonium nitrate).

After the surface treatment liquid according to the present invention is brought into contact with the surface of copper, a treatment liquid containing a known organic compound-based rust inhibitor such as a benzotriazole-based rust inhibitor may be brought into contact therewith.

The surface treatment liquid according to the present invention can be used for treating the surface of at least one base material selected from the group consisting of a metal, an inorganic material, and a resin material. By treating the surface of the base material with the surface treatment liquid according to the present invention, a chemical conversion film can be formed on the surface of the base material, and adhesiveness to other materials can be enhanced.

In the present invention, two materials selected from the group consisting of the metal, the inorganic material, and the resin material can adhere to each other by using the surface treatment liquid according to the present invention. The affinity between the two materials can be improved by adhering the two materials to each other through the layer of the chemical conversion film formed by the surface treatment liquid according to the present invention, and therefore, even materials of different properties can adhere to each other more firmly.

### (Adhesion Method)

The two materials can adhere to each other by a known method. Examples of the known method include a method of bringing the surface treatment liquid according to the present invention into contact with a surface of a base material made of a metal, an inorganic material, or a resin material to form a chemical conversion film, and adhering another base material to a part of or the whole of the formed chemical conversion film by a method such as coating, pressure bonding, and mixing, use of an adhesive or an adhesive sheet (film), or a combination of these methods.

Examples of the known method include a method of bringing the surface treatment liquid according to the present invention into contact with surfaces of two base materials selected from a metal, an inorganic material, and a resin material to respectively form chemical conversion films on the surfaces of the two base materials, and adhering the two base materials to each other by a method such as coating, pressure bonding, and mixing, use of an adhesive or an adhesive sheet (film), or a combination of these methods.

The two materials, in particular, two materials with different properties can be adhered to each other as described above by using the surface treatment liquid according to the present invention, and therefore, the surface treatment liquid can be suitably used for various electric and electronic components, semiconductor wafers, and electronic devices such as printed wiring boards.

In the present invention, the surface treatment liquid according to the present invention can be suitably used for a base material formed of a metal, particularly copper or a copper alloy. For example, the surface treatment liquid is suitable for a surface treatment of copper or a copper alloy for the purpose of enhancing adhesion (adhesiveness) between a copper circuit (copper wiring layer) and a semi-cured or cured prepreg or solder resist, or semi-cured or cured dry film resist (insulating resin layer). In a printed wiring board having an insulating resin layer in contact with the copper wiring layer, adhesion between the copper wiring layer and the insulating resin layer can be enhanced.

In an application example in a semiconductor wafer, the surface treatment liquid is suitable for a surface treatment of a semiconductor circuit for the purpose of enhancing adhesion (adhesiveness) between a semiconductor circuit formed on a semiconductor wafer and a protective film (for example, an insulating protective film such as a photosensitive positive-type buffer coat, a photosensitive negative-type buffer coat, a non-photosensitive buffer coat, or a bump protective film).

Further, in a package substrate (WL-CSP, FO-WLP, PLP), a 2.5-dimensional (2.5D) interposer substrate, or a three-dimensional (3D) interposer substrate in which a rewiring layer is formed on a semiconductor wafer, the surface treatment liquid is suitable for a surface treatment of a copper circuit rewiring layer for the purpose of enhancing adhesion (adhesiveness) between the copper circuit rewiring layer and an insulating material.

Examples of the protective film and the insulating material include a polyimide resin, a polybenzoxazole resin, and a silicone resin.

The printed wiring board can be produced by bringing a surface of a copper wire into contact with the surface treatment liquid according to the present invention, followed by washing with water and drying, and then forming an insulating resin layer on the surface of the copper wire. The method of this contact is as described above, and immersion of the copper wiring in the surface treatment liquid, spraying of the treatment liquid to the copper wire, or the like is simple and reliable and thus, is preferable.

The method of washing with water is not particularly limited, and immersion of the copper wire in the washing water or spraying of the washing water to the surface of the copper wire is easy and reliable and thus, is preferable.

The insulating resin layer can be formed by a known method, for example, a method of attaching a semi-cured resin material or a method of applying a liquid resin material containing a solvent. Then, a via hole is formed to electrically connect the upper and lower wires. A multilayer printed wiring board can be produced by repeating this process.

In a method for forming a circuit of the printed wiring board, an example of a semi-additive method using the surface treatment liquid according to the present invention is described below.

A method for producing a circuit substrate includes at least one of:
(a) a step of preparing an insulating substrate or an insulating substrate having through-holes and via holes, the insulating substrate having a first conductive layer on a first surface, a second surface opposite to the first surface, and inner walls of the through-holes and the via holes;
(b) a step of forming a photo-crosslinkable resin layer and a mask layer on the first surface and the second surface, to cover the first conductive layer on the first surface, the second surface, and the inner walls of the through-holes and the via holes with the photo-crosslinkable resin layer and the mask layer;
(c) a step of pattern-exposing the photo-crosslinkable resin layer on the first surface, the second surface, and peripheries of the through-holes and the via holes;
(d) a step of removing the mask layer on the first surface, the second surface, and the peripheries of the through-holes and the via holes;
(e) a step of developing and removing uncured photo-crosslinkable resin layer on the first surface, the second surface, and the peripheries of the through-holes and the via holes by using a photo-crosslinkable resin layer-removing solution, to expose the first conductive layer on the first surface, the first conductive layer on the second surface, and the first conductive layer on the peripheries of the through-holes and the via holes;
(f) a step of forming a second conductive layer on the first conductive layer exposed to the first surface, the second surface, and the inner walls of the through-holes and the via holes by electrolytic plating;
(g) a step of removing the cured photo-crosslinkable resin layer on the first surface, the second surface, and the peripheries of the through-holes and the via holes to expose the first and second conductive layers on the first surface, the second surface, and the inner walls of the through-holes and the via holes;
(h) a step of removing the exposed first conductive layer by flash etching;
(i) a step of forming a third conductive layer on the first and second conductive layers of the first surface, the second surface and the inner walls of the through-holes and the via holes by electroless plating and electrolytic plating; and
(j) a step of laminating an insulating resin layer on the first, second, and third conductive layers on the first surface, the second surface, and the inner walls of the through-holes and the via holes,
and in this method, the surface treatment liquid according to the present invention is brought into contact with at least one metal layer or resist layer among the first, second, and third conductive layers on the first surface, the second surface, and the inner walls of the through-holes and via holes, the insulating resin substrate, the photo-crosslinkable resin layer used for the etching resist layer or plating resist layer, and the insulating resin layer, to thereby produce a printed wiring board.

Further, in the method for forming a circuit of the printed wiring board, an example of a subtractive construction method using the surface treatment liquid according to the present invention is described below.

A method for producing a circuit substrate includes at least one of:
(a) a step of preparing an insulating substrate or an insulating substrate having through-holes and via holes, the insulating substrate having a first conductive layer on a first surface, a second surface opposite to the first surface, and inner walls of the through-holes and the via holes;
(b) a step of forming a photo-crosslinkable resin layer and a mask layer on the first surface and the second surface, to cover the first conductive layer on the first surface, the second surface, and the inner walls of the through-holes and the via holes with the photo-crosslinkable resin layer and the mask layer;
(c) a step of pattern-exposing the photo-crosslinkable resin layer on the first surface, the second surface, and peripheries of the through-holes and the via holes;
(d) a step of removing the mask layer on the first surface, the second surface, and the peripheries of the through-holes and the via holes;
(e) a step of developing and removing uncured photo-crosslinkable resin layer on the first surface, the second surface, and the peripheries of the through-holes and the via holes by using a photo-crosslinkable resin layer-removing solution, to expose the first conductive layer on the first surface, the first conductive layer on the second surface, and the first conductive layer on the peripheries of the through-holes and the via holes;
(f) a step of removing the first conductive layer exposed to the first surface, the second surface, and the inner walls of the through-holes and the via holes by etching;
(g) a step of removing the cured photo-crosslinkable resin layer on the first surface, the second surface, and the peripheries of the through-holes and the via holes to expose the first conductive layer on the first surface, the second surface, and the inner walls of the through-holes and the via holes;
(h) a step of forming a second conductive layer on the first conductive layers of the first surface, the second surface and the inner walls of the through-holes and the via holes by electroless plating and electrolytic plating; and
(i) a step of laminating an insulating resin layer on the first and second conductive layers on the first surface, the second surface, and the inner walls of the through-holes and the via holes,
and in this method, the surface treatment liquid according to the present invention is brought into contact with at least one metal layer or resist layer among the first and second conductive layers on the first surface, the second surface, and the inner walls of the through-holes and via holes, the insulating resin substrate, the photo-crosslinkable resin layer used for the etching resist layer or plating resist layer, and the insulating resin layer, to thereby produce a printed wiring board.

The copper wire and the conductive layer may be produced by any method such as an electroless plating method, an electrolytic plating method, a vapor deposition method, a sputtering method, and a damascene method, and may include an inner via hole, a through hole, a connection terminal, and the like.

In addition, the "copper" according to the present invention is used in applications and forms of a foil (an electrolytic copper foil, a rolled copper foil, a resin-attached copper foil, a carrier-attached copper foil, an electroless copper foil, a sputtered copper foil, and a thin copper foil), a plating film (an electroless copper plating film and an electrolytic copper plating film), a thin film formed by a vapor deposition method, a sputtering method, a damascene method, and the like, a particle, a needle, a fiber, a wire, a rod, a tube, a plate, and the like used for an electronic device such as a printed wiring board and a lead frame, a decorative article, a building material, and the like. In the case of recent copper wires through which high-frequency electric signals flow, the surface of copper is preferably a smooth surface having an average roughness of 0.1 µm or less. The surface of copper may be plated with nickel, zinc, chromium, tin, or the like as a pretreatment.

Further, for example, in an application example in a lead frame during wire bonding mounting, the surface treatment liquid according to the present invention is suitable for surface treatment of the lead frame for the purpose of enhancing adhesion (adhesiveness) between a sealing resin or an adhesive during mounting of a semiconductor chip and a metal surface in a lead frame producing step, a frame metal surface after mounting a semiconductor chip (before and after a die bonding and pre-baking step), a frame metal surface after wire bonding mounting, or a frame metal surface during the step up to resin sealing (before and after a resin molding and baking step).

Further, for example, in an application example in a lead frame during flip-chip mounting, the surface treatment liquid according to the present invention is suitable for a surface treatment of the lead frame for the purpose of enhancing adhesion (adhesiveness) between a sealing resin or an adhesive during mounting of a semiconductor chip and a metal surface in a lead frame producing step, a metal surface of a lead frame after a joining material (solder, Au plating, Sn plating, or the like) is temporarily placed, a metal surface of a frame after mounting a semiconductor chip (alignment, before or after a chip mounting and baking step), a metal surface of a lead frame after main curing (before or after a step of reflow heating, thermocompression bonding, ultrasonic, plasma, or the like), or a metal surface of a lead frame during the step up to resin sealing.

Further, for example, in an application example in a fine wiring substrate in which an integration technology for closely disposing a semiconductor chip is enhanced, the surface treatment liquid according to the present invention is also suitable for a surface treatment of a copper circuit wiring layer for the purpose of enhancing adhesion (adhesiveness) between the copper circuit wiring layer and an insulating material in a 2.5-dimensional (2.5D) organic substrate or glass substrate, a component-embedded substrate (EPS substrate) in which a semiconductor is embedded in a substrate, or a coreless substrate.

Further, for example, the surface treatment liquid for metal according to the present invention is suitable for a surface treatment of a copper circuit wiring layer for the purpose of enhancing adhesion (adhesiveness) between the copper circuit wiring layer and an insulating material in the case of performing via fill plating after embedding patterned wiring and processing interlayer connections with laser vias, or in the case of using a circuit-embedded substrate (ETS substrate) with MIS structure, where interlayer conduction is achieved via copper pillars formed by plating and a mold resin is used in an insulating layer.

The carrier-attached copper foil treated with the surface treatment liquid according to the present invention refers to an ultrathin electrolytic copper foil used for a printed wiring board including a step of forming a circuit by any one of a semi-additive method, a subtractive method, a partly additive method, and a modified semi-additive method, and includes a copper foil carrier, a release layer laminated on the copper foil carrier, and an ultrathin copper layer laminated on the release layer. The surface of copper may be subjected to at least one pretreatment selected from the group consisting of pickling treatment, roughening treatment, heat resistance treatment, rust prevention treatment, and chemical conversion treatment.

### (Insulating Composition)

An insulating composition can be formed when a resin material or an inorganic material contains the coupling agent according to the present invention.

The insulating composition can also be obtained by dissolving the tetrazole compound (I) in an organic solvent or the like and mixing the resultant with a resin material or an inorganic material.

The content of the tetrazole compound (I) in the insulating composition is preferably 0.001 wt% to 10 wt%, and more preferably 0.01 wt% to 5 wt%. In the case where the content of the tetrazole compound (I) is 0.001 wt% or more in the insulating composition, the effect of improving adhesion is sufficiently obtained, and in the case where the concentration exceeds 10 wt%, the effect of improving adhesion substantially reaches a peak. Therefore, from an economical viewpoint, the content of the tetrazole compound (I) is preferably 10 wt% or less.

The insulating composition can be produced by a known method. For example, the insulating composition can be produced by dissolving the tetrazole compound (I) in an organic solvent and mixing the resulting solution with a solid or liquid resin material. Alternatively, the tetrazole compound (I) may be directly added to and mixed with a liquid resin material to prepare an insulating composition.

The insulating composition according to the present invention forms an insulating material having high adhesive strength, and therefore, the insulating composition can be suitably used for various electrical and electronic components and electronic devices such as printed wiring boards.

JP 2009-19266A describes an invention related to a method for forming a silane coupling agent film. The method includes a step of applying a liquid containing a silane coupling agent to a metal surface, a step of drying the metal surface to which the liquid is applied at a temperature of 25°C to 150°C for 5 minutes or shorter, and a step of washing the dried metal surface with water.

In addition, it is said that an adhesive metal layer made of tin or the like may be formed on the metal surface in advance by an immersion plating solution as a surface treatment.

The surface treatment liquid according to the present invention can be used as a liquid containing the silane coupling agent. It should be noted that the matters described in the patent publication are incorporated herein by reference.

### [Examples]

Hereinafter, the present invention will be specifically described with reference to Examples (synthesis tests and evaluation tests), but the present invention is not limited thereto.

In the chemical formulas shown below, OEt represents an ethoxy group.

Tetrazole compounds and a halogenated alkylsilane compound as raw materials used in the synthesis test are as follows.

### [Tetrazole Compound]

- Tetrazole compound (5,5'-bi(1,2,3,4-tetrazole)diammonium salt) represented by the following chemical formula (11): manufactured by FUJIFILM Wako Pure Chemical Corporation
- Tetrazole compound (5,5'-ethylenebis(1,2,3,4-tetrazole)) represented by the following chemical formula (12): synthesized according to the method described in WO2015/084830.

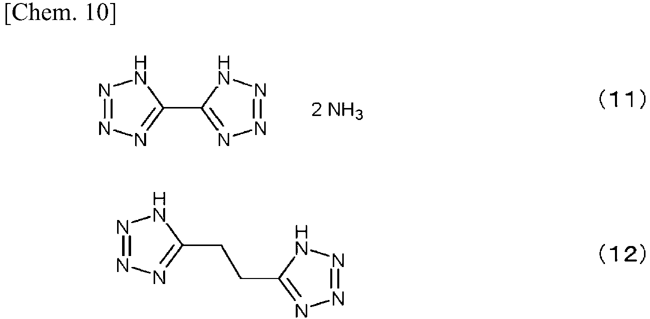

### [Halogenated Alkylsilane Compound]

- 3-Chloropropyltriethoxysilane: manufactured by Tokyo Chemical Industry Co., Ltd.

### <Synthesis of Tetrazole Compound (I)>

The tetrazole compounds of Examples 1 and 2 below were synthesized.

### [Example 1]

### <Synthesis of Mixture of 1-[3-(triethoxysilyl)propyl]-5,5'-bi(1,2,3,4-tetrazole) and 2-[3-(triethoxysilyl)propyl]-5,5'-bi(1,2,3,4-tetrazole)>

A compound represented by the following chemical formula (1) (a mixture of 1-[3-(triethoxysilyl)propyl]-5,5'-bi(1,2,3,4-tetrazole) and 2-[3-(triethoxysilyl)propyl]-5,5'-bi(1,2,3,4-tetrazole)) was synthesized.

A suspension containing 17.0 g (98.7 mmol) of 5,5'-bi(1,2,3,4-tetrazole)diammonium salt and 182 mL of dimethyl sulfoxide was heated to 70°C, 33.6 g (98.7 mmol) of a 20% sodium ethoxide ethanol solution was added thereto, and the temperature was raised to 100°C, followed by stirring for 1 hour. Next, after cooling to 70°C, 23.8 g (98.8 mmol) of 3-chloropropyltriethoxysilane was added, followed by stirring for 10 minutes. Subsequently, the temperature was raised to 100°C, followed by stirring for 20 hours. The reaction solution was cooled to room temperature, insoluble matter was filtered off, and the filtrate was distilled off under reduced pressure. Further, 455 mL of isopropyl acetate was added, followed by stirring at room temperature for 1 hour, insoluble matter was filtered off, and the filtrate was distilled off under reduced pressure, to obtain 30.7 g (89.7 mmol, yield: 91%) of a pale brown liquid.

The ¹H-NMR spectral data of the obtained pale brown liquid was as follows.

¹H-NMR (DMSO-d₆) δ: 0.50 (m, 2H), 1.13 (m, 9H), 2.00 (m, 2H), 3.73 (m, 6H), 4.84 (m, 2H).

From the ¹H-NMR spectral data, the obtained pale brown liquid was identified as the tetrazole compounds in the title, which were represented by the chemical formula (1).

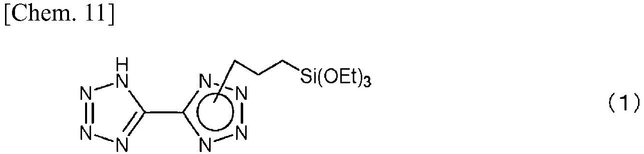

### [Example 2]

### <Synthesis of Mixture of 1-[3-(triethoxysilyl)propyl]-5,5'-ethylenebis(1,2,3,4-tetrazole) and 2-[3-(triethoxysilyl)propyl]-5,5'-ethylenebis(1,2,3,4-tetrazole)>

A compound represented by the following chemical formula (2) (a mixture of 1-[3-(triethoxysilyl)propyl]-5,5'-ethylenebis(1,2,3,4-tetrazole) and 2-[3-(triethoxysilyl)propyl]-5,5'-ethylenebis(1,2,3,4-tetrazole)) was synthesized.

A suspension containing 9.5 g (57.2 mmol) of 5,5'-ethylenebis(1,2,3,4-tetrazole) and 62 mL of N,N-dimethylacetamide was heated to 50°C, 20.0 g (58.8 mmol) of a 20% sodium ethoxide ethanol solution was added thereto, and the temperature was raised to 70°C, followed by stirring for 1 hour. Next, 13.8 g (57.3 mmol) of 3-chloropropyltriethoxysilane was added thereto, followed by stirring for 10 minutes. Subsequently, the temperature was raised to 100°C, followed by stirring for 20 hours. After the reaction solution was cooled to 60°C, the filtrate was distilled off under reduced pressure. Subsequently, 120 mL of isopropyl acetate was added, followed by stirring at room temperature for 1 hour, insoluble matter was filtered off, and the filtrate was distilled off under reduced pressure, to obtain 18.4 g (49.7 mmol, yield: 87%) of a pale brown liquid.

### The ¹H-NMR spectral data of the obtained pale brown liquid was as follows.

¹H-NMR (DMSO-d₆) δ: 0.51 (m, 1.5H), 0.58 (m, 0.5H), 1.12 (m, 9H), 1.92 (m, 2H), 3.35 (m, 4H), 3.74 (m, 6H), 4.33 (m, 0.5H), 4.57 (m, 1.5H).

From the ¹H-NMR spectral data, the obtained pale brown liquid was identified as the tetrazole compounds in the title, which were represented by the chemical formula (2).

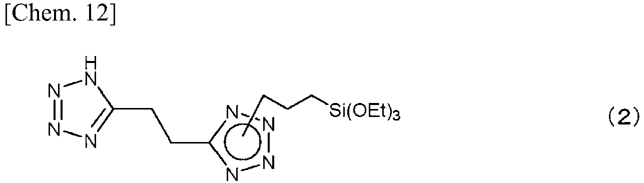

### <Adhesion Test 1>

The surface treatment liquids prepared in Examples 3 and 4 below were evaluated for adhesion as follows.

### [Adhesion Evaluation Test (i)]

### (1) Metal

An electrolytic copper foil (thickness: 35 µm) was used as the metal.

### (2) Surface Treatment of Metal

The copper foil was treated according to the following steps a and b.
a. Acid cleaning (5% sulfuric acid aqueous solution)/1 minute (at room temperature), and washing with water.
b. Applying the surface treatment liquid with a brush, and drying/1 minute (at 100°C).

### (3) Adhering between Metal and Resin

A glass cloth epoxy resin-impregnated prepreg (MEGTRON7 (manufactured by Panasonic Corporation)) was laminated and pressed on an S surface of the treated copper foil, and the copper foil was adhered to the prepreg to produce a copper-clad laminate.

### (4) Evaluation of Adhesion

For this copper-clad laminate, a test piece having a width of 10 mm was prepared in accordance with "JIS C6481 (1996)" after reflow heating (peak temperature: 288°C, atmosphere) was performed one time, and the peel strength (kN/m) of the copper foil was measured.

### [Example 3]

After 99.5 g of a mixed solution (weight ratio) of acetic acid: ion-exchanged water: methanol = 1: 8: 90.5 was added to 0.5 g of the tetrazole compound represented by the chemical formula (1) as a coupling agent component, the mixture was stirred at room temperature for 1 hour to prepare a surface treatment liquid.

### [Example 4]

A surface treatment liquid was prepared in the same manner as in Example 3 except that the tetrazole compound represented by the chemical formula (2) was used instead of the tetrazole compound represented by the chemical formula (1).

Each of the surface treatment liquids prepared above was subjected to the adhesion evaluation test (i). The obtained test results are shown in Table 1.

### [Comparative Example 1]

The copper foil subjected to only step (2) a. of the adhesion evaluation test (i) was subjected to the adhesion evaluation test (i). The obtained test results are shown in Table 1.

### [Table 1]

**Table 1**

| | | Coupling agent | Peel strength (kN/m) |
|---|---|---|---|
| Examples | 3 | Tetrazole compound (1) | 0.40 |
| | 4 | Tetrazole compound (2) | 0.55 |
| Comparative Example | 1 | No | 0.09 |

From the results of Table 1, it was found that the surface treatment liquid according to the present invention (the surface treatment liquids in Examples 3 and 4) had a higher peel strength than Comparative Example 1 and was excellent in adhesiveness between a metal and a resin.

### <Adhesion Test 2>

The surface treatment liquid prepared in Example 5 below was evaluated for adhesion as follows.

### [Adhesion Evaluation Test (ii)]

### (1) Metal

An electrolytic copper foil (thickness: 35 µm) was used as the metal.

### (2) Surface Treatment of Metal

The copper foil was treated according to the following steps a and b.
a. Acid cleaning (5% hydrochloric acid aqueous solution)/1 minute (at room temperature), and washing with water.
b. Immersing in a surface treatment liquid/2 minutes (at 30°C), washing with water, and drying/1 minute (at 100°C).

### (3) Adhering between Metal and Resin

The S surface of the treated copper foil was coated with polyimide varnish (trade name, "U-Varnish A" manufactured by UBE) with a bar coater so as to have a thickness of 100 µm, followed by curing (at 120°C for 30 minutes, at 150°C for 10 minutes, at 200°C for 10 minutes, and at 250°C for 10 minutes) in a nitrogen atmosphere to prepare a copper-clad laminate.

### (4) Evaluation of Adhesion

This copper-clad laminate was held in an oven at 150°C for 250 hours in the atmosphere (HTS treatment). Thereafter, a test piece having a width of 10 mm was prepared in accordance with "JIS C6481 (1996)", and the peel strength (kN/m) of the copper foil was measured.

### [Example 5]

After adding 99.5 g of a mixed solution (weight ratio) of acetic acid: ion exchanged water = 5: 95 to 0.5 g of the tetrazole compound represented by the chemical formula (2) as a coupling agent component, the pH was adjusted to 7.1 with ammonia water, and the mixture was stirred at room temperature for 1 hour to prepare a surface treatment liquid.

Each of the surface treatment liquids prepared above was subjected to the adhesion evaluation test (ii). The obtained test results are shown in Table 2.

### [Comparative Example 2]

The copper foil subjected to only step (2) a. of the adhesion evaluation test (ii) was subjected to the adhesion evaluation test (ii). The obtained test results are shown in Table 2.

### [Table 2]

**Table 2**

| | | Coupling agent | Peel strength (kN/m) |
|---|---|---|---|
| Example | 5 | Tetrazole compound (2) | 0.36 |
| Comparative Example | 2 | No | 0.06 |

From the results of Table 2, it was found that the surface treatment liquid according to the present invention (the surface treatment liquid in Example 5) had a higher peel strength than Comparative Example 2 and was excellent in adhesiveness between a metal and a resin.

Although the present invention has been described in detail with reference to specific embodiments, it is apparent to those skilled in the art that various changes and modifications can be made without departing from the spirit and scope of the present invention. The present application is based on Japanese Patent Application (No. 2023-138677) filed on August 29, 2023, the contents of which are incorporated herein by reference.

### INDUSTRIAL APPLICABILITY

The tetrazole compound according to the present invention can be used as a coupling agent having a function of preventing a metal from rusting, which is a feature of the tetrazole compound, and a function of curing an epoxy resin or a urethane resin, and therefore, the tetrazole compound is expected to be used for a composite material such as a printed wiring board produced by combining a large number of different types of materials.

In addition, according to the present invention, the adhesion (adhesiveness) of a metal, an inorganic material, and a resin material can be enhanced, and therefore, the surface of the base material can be maintained in a smooth state without being roughened. Therefore, since the present invention can greatly contribute to the implementation of miniaturization, thinning, high frequency, high density, and the like of a multilayer printed wiring board, industrial applicability is great.

## Claims

1. A tetrazole compound represented by the chemical formula (I): 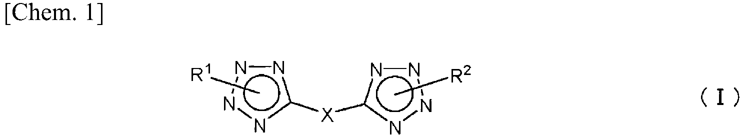 (in the formula (I), R¹ and R² are the same as or different from each other, and each represent a hydrogen atom or a group represented by -(CH₂)ₘ-Si(OR)₃₋ₚ(OH)ₚ, in which R represents a methyl group or an ethyl group, m represents an integer of 1 to 18, and p represents an integer of 0 to 3, X represents a phenylene group, -NH-, or a group represented by -(CH₂)ₙ-, and n represents an integer of 0 to 12, and wherein the case where R¹ and R² are hydrogen atoms at the same time is excluded).

2. A method for synthesizing the tetrazole compound according to claim 1, the method comprising reacting a tetrazole compound represented by the chemical formula (II) and a halogenated alkylsilane compound represented by the chemical formula (III): 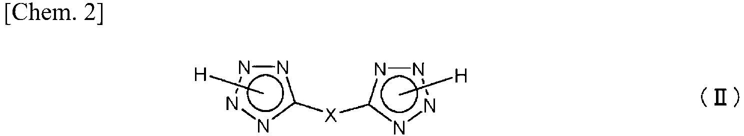 (in the formula (II), X is the same as that described above), and
[Chem. 3]
Hal-(CH₂)ₘ-Si(OR)₃₋ₚ(OH)ₚ (III)
(in the formula (III), R, m, and p are the same as those described above, and Hal represents a fluorine atom, a chlorine atom, a bromine atom, or an iodine atom).

3. A coupling agent comprising the tetrazole compound according to claim 1 as a component.

4. A surface treatment liquid comprising the tetrazole compound according to claim 1.

5. The surface treatment liquid according to claim 4, which is used for treating a surface of at least one selected from the group consisting of a metal, an inorganic material, and a resin material.

6. The surface treatment liquid according to claim 4, which is used for adhering two materials selected from the group consisting of a metal, an inorganic material, and a resin material to each other.

7. The surface treatment liquid according to claim 5 or 6, wherein the metal is at least one selected from the group consisting of copper, aluminum, titanium, nickel, tin, iron, silver, gold, and alloys thereof.

8. A surface treatment method comprising: bringing the surface treatment liquid according to claim 4 into contact with a surface of at least one selected from the group consisting of a metal, an inorganic material, and a resin material.

9. The surface treatment method according to claim 8, wherein the metal is at least one selected from the group consisting of copper, aluminum, titanium, nickel, tin, iron, silver, gold, and alloys thereof.

10. The surface treatment method according to claim 9, wherein the metal is copper or a copper alloy.

11. The surface treatment method according to claim 10, wherein an aqueous solution containing a copper ion is brought into contact with a surface of the copper or the copper alloy before the surface treatment liquid is brought into contact with the surface of the copper or the copper alloy.

12. The surface treatment method according to claim 10 or 11, wherein after the surface treatment liquid is brought into contact with the surface of the copper or the copper alloy, an acidic aqueous solution or an alkaline aqueous solution is brought into contact with the surface of the copper or the copper alloy.

13. An adhesion method comprising: bringing the surface treatment liquid according to claim 4 into contact with at least one selected from the group consisting of a metal, an inorganic material, and a resin material to form a chemical conversion film on the at least one; and adhering the at least one and another one of the group to each other via the chemical conversion film.

14. A method for adhering a metal and a resin material to each other, the method comprising: bringing the surface treatment liquid according to claim 4 into contact with at least one of the metal and the resin material to form a chemical conversion film on the at least one; and adhering the metal and the resin material to each other via the chemical conversion film.

15. A printed wiring board in which two materials selected from the group consisting of a metal, an inorganic material, and a resin material adhere to each other via a chemical conversion film formed of the surface treatment liquid according to claim 4.

16. A semiconductor wafer in which two materials selected from the group consisting of a metal, an inorganic material, and a resin material adhere to each other via a chemical conversion film formed of the surface treatment liquid according to claim 4.

17. An insulating composition comprising the coupling agent according to claim 3 and a resin material or an inorganic material.

18. An insulating material comprising the insulating composition according to claim 17.

19. A printed wiring board comprising an insulating layer obtained from the insulating composition according to claim 17.

20. A semiconductor wafer comprising an insulating layer obtained from the insulating composition according to claim 17.
